Europäisches Patentamt

European Patent Office

Office européen des brevets

(11) Veröffentlichungsnummer: **0 218 849**
**A1**

(12) **EUROPÄISCHE PATENTANMELDUNG**

(21) Anmeldenummer: 86111438.7

(22) Anmeldetag: 19.08.86

(51) Int. Cl.⁴: **H01L 23/48** , H01L 23/56

(30) Priorität: 12.09.85 DE 3532601

(43) Veröffentlichungstag der Anmeldung:
22.04.87 Patentblatt 87/17

(84) Benannte Vertragsstaaten:
AT DE FR GB

(71) Anmelder: **Siemens Aktiengesellschaft Berlin und München**
**Wittelsbacherplatz 2**
**D-8000 München 2(DE)**

(72) Erfinder: **Rohde, Volker, Dipl.-Ing. (FH)**
**Buchenstrasse 10a**
**D-8011 Forstinning(DE)**
Erfinder: **Schmitter, Detlev, Dipl.-Ing. (FH)**
**Risserkoglstrasse 2**
**D-8000 München 80(DE)**

(54) **Trägerband für einen filmmontierten Schaltkreis.**

(57) Zur Vermeidung der Zerstörung von Halbleiterchips (1), insbesondere von solchen in MOS-Technologie, durch elektrostatische Entladungen enthält ein handelsüblicher Kleber (z.B. Silikon-, Epoxi-, Acrylkleber) eine Beimengung elektrisch leitfähigen Materials wie Ruß und/oder Graphit. Damit sind alle Anschlüsse des Halbleiterchips (1) hochohmig miteinander verbunden.

FIG 1

EP 0 218 849 A1

## Trägerband für einen filmmontierten Schaltkreis

Die Erfindung betrifft ein Trägerband für einen filmmontierten Schaltkreis, das eine Kleberschicht aufweist.

Aus der DT 24 14 297 A1 ist ein gattungsgemäßes Trägerband bekannt. Es kann beispielsweise im wesentlichen aus Polyimidmaterial bestehen. Bei der Verwendung als Trägerband für einen filmmontierten Schaltkreis, bekannt unter dem Begriff "Mikropack", weist das Trägerband mindestens auf einer seiner Hauptflächen zunächst ganzflächig eine elektrisch gut leitende Folie auf - (z.B. eine Kupferfolie), die dann im Laufe weiterer Montageschritte zu Leiterbahnen strukturiert wird. Diese Leiterbahnen sind beim fertigen Produkt in elektrisch gut leitendem Kontakt mit einem integrierten Halbleiterchip. Die elektrisch gut leitende Folie ist mittels einer elektrisch isolierenden Kleberschicht, beispielsweise aus Epoxidharz, mit dem Trägerband verklebt ("kaschiert").

Soll der fertige filmmontierte Schaltkreis nun Halbleiterchips in MIS-oder MOS-Technologie enthalten, so besteht, wie für MOS-Schaltkreise allgemein bekannt, die große Gefahr, daß bei unsachgemäßem Handling des filmmontierten Schaltkreises elektrische Eingänge des Halbleiterchips elektrostatisch aufgeladen werden. Dies kann bei einer plötzlichen Entladung zur Zerstörung des Halbleiterchips führen.

Aus diesem Grunde gibt es für Personen, die mit MOS-Schaltkreisen umgehen, sogenannte Handling-Vorschriften, die besagen, daß jede betroffene Person während des Umganges mit MOS-Schaltkreisen hochohmig (z.B. 10 MOhm) mit Erde verbunden sein muß. Damit werden elektrostatische Aufladungen bereits zum Zeitpunkt ihres Entstehens abgebaut und "unschädlich" gemacht. Letztendlich scheitern jedoch solche Vorschriften an menschlichen Unzulänglichkeiten: Man vergißt, sich zu erden, oder man unterläßt es absichtlich, beispielsweise aus Bequemlichkeitsgründen.

Die DE-OS 31 30 324 sieht deshalb beispielsweise bei filmmontierten Schaltkreisen, insbesondere solchen für elektronische Scheckkarten, mit aus der obengenannten elektrisch gut leitfähigen Folie strukturierten Leiterbahnen vor, immer dann mittels eines sogenannten Masseringes sämtliche Eingänge, Ausgänge und Versorgungsanschlüsse miteinander elektrisch kurzzuschließen, so daß sie nicht untereinander unterschiedlich hohe Potentiale durch elektrostatische Aufladung annehmen können, wenn die filmmontierten Schaltkreise elektrisch nicht betrieben werden. Dies schließt zwar den negativen Einfluß menschlicher Unzulänglichkeiten, wie oben genannt, aus. Aufgrund der notwendigen mechanischen Bewegungen -

(Abheben des Masseringes von den Leiterbahnen zu Beginn des elektrischen Betriebes und anschließendes Wiederherstellen der Masseverbindung) ist jedoch ein einwandfreier Kurzschluß der Leiterbahnen mit dem Massering im nicht-betriebenen Zustand nicht immer gewährleistet, insbesondere bei auftretenden Verschleißerscheinungen.

Aufgabe der vorliegenden Erfindung ist es deshalb, ein gattungsgemäßes Trägerband zu -schaffen, das den zugehörigen Halbleiterchip zuverlässig vor Zerstörung durch elektrostatische Entladung schützt.

Diese Aufgabe wird durch die kennzeichnenden Merkmale des Patentanspruches 1 gelöst. Vorteilhafte Aus-und Weiterbildungen sind in Unteransprüchen gekennzeichnet.

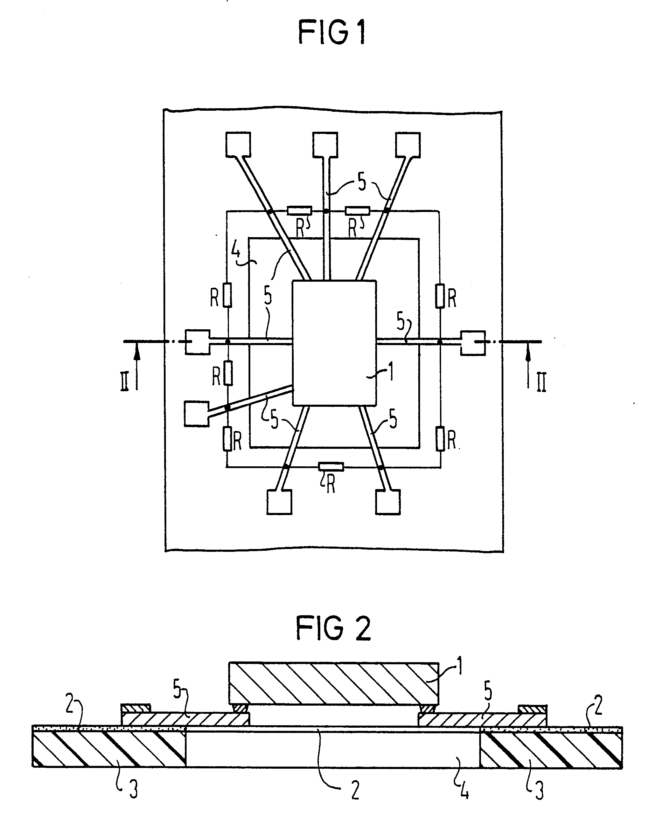

Die Erfindung wird im folgenden anhand der Figuren 1 und 2 detailliert beschrieben. Es zeigen:

Fig. 1 einen filmmontierten Schaltkreis in Draufsicht,

Fig. 2 den filmmontierten Schaltkreis im Querschnitt.

Fig. 1 zeigt einen filmmontierten Schaltkreis mit einem Halbleiterchip 1, der vorzugsweise ein Halbleiterchip in MOS-Technologie ist. Der Halbleiterchip 1 ist über elektrische Leiterbahnen 5 mit einem, in Fig. 2 sichtbaren, Trägerband 3 verbunden. Dieses kann, wie allgemein bekannt, aus Kunststoff bestehen wie z.B. aus Polyimid oder Polyester. Es weist im allgemeinen einen Ausschnitt 4 auf, der zur Aufnahme des Halbleiterchips 1 dient. Die Verbindung der Leiterbahnen 5 mit dem Trägerfilm 3 erfolgt, wie in Fig. 1 und 2 gut sichtbar, mittels einer auf dem Trägerfilm 3 großflächig aufgebrachten Kleberschicht 2. Erfindungsgemäß ist diese Kleberschicht 2 hochohmig leitend. Sie verbindet erfindungsgemäß alle Leiterbahnen 5 hochohmig miteinander, was in Fig. 1 symbolisch durch die eingezeichneten Widerstände R angedeutet ist.

Die elektrische Leitfähigkeit kann auf eine Beimengung von elektrisch leitfähigem Material zu handelsüblichen Klebern beruhen. Als Beimengung eignen sich insbesondere Ruß und/oder Graphit. Über den Anteil der Beimengung des elektrisch leitfähigen Materials an der genannten Kleberschicht 2 läßt sich deren Leitfähigkeit einstellen auf ein gewünschtes Maß.

Aus elektrischen Gründen ist es notwendig, daß die Leitfähigkeit der Kleberschicht 2 zwischen den einzelnen Leiterbahnen 5 einen bestimmten Maximal-Wert nicht übersteigt. Ein genauer Wert läßt sich nicht allgemein angeben, er ist im Einzelfall zu ermitteln u.a. aus einem minimalen Strom, den einerseits Treiber von Ausgangsstufen eines auf dem Trägerband zu montierenden Halbleiterchips 1 zu erzeugen in der Lage sind und den andererseits Eingänge des Halbleiterchips 1 ansteuernde externe Beschaltungen zu erzeugen in der Lage sind. Nur dann sind nämlich für einen ordnungsgemäßen Betrieb des Halbleiterchips 1 notwendige elektrische Signale gewährleistet.

Als gut geeignete Kleber für die Beimengung elektrisch leitfähigen Materials haben sich insbesondere Silikonkleber, Epoxi-und Acrylkleber erwiesen.

Die vorliegende Erfindung gestattet es durch die ständige, permanente hochohmige Verbindung der Leiterbahnen 5 untereinander, einerseits den Halbleiterchip 1 elektrisch einwandfrei betreiben zu können und andererseits jegliche elektrostatische Aufladung sofort beim Entstehen wieder abzuleiten.

Die Erfindung läßt sich anwenden unter anderem für elektronische Scheckkarten, Telefonkarten und für Herzschrittmacher.

Bezugszeichenliste

1 Halbleiterchip
2 Kleberschicht
3 Trägerband
4 Auschnitt
5 Leiterbahn
R Widerstand als Symbol für hochohmige Verbindung

**Ansprüche**

1. Trägerband für einen filmmontierten Schaltkreis, das eine Kleberschicht aufweist,

**dadurch gekennzeichnet,**

daß die Kleberschicht (2) elektrisch hochohmig leitfähig ist.
2. Trägerband nach Anspruch 1,

**dadurch gekennzeichnet,**

daß die Leitfähigkeit auf Beimengung eines leitfähigen Materials zu einem handelsüblichen Kleber als Basismaterial beruht.
3. Trägerband nach Anspruch 1 oder 2,

**dadurch gekennzeichnet,**

daß die Leitfähigkeit der Kleberschicht (2) durch eine unterschiedliche Menge der Beimengung einstellbar ist.

4. Trägerband nach einem der vorhergehenden Ansprüche,

**dadurch gekennzeichnet,**

daß das leitfähige Material Ruß ist.
5. Trägerband nach einem der vorhergehenden Ansprüche,

**dadurch gekennzeichnet,**

daß das leitfähige Material Graphit ist.
6. Trägerband nach einem der Ansprüche 1 bis 5,

**dadurch gekennzeichnet,**

daß der als Basismaterial dienende Kleber ein Silikonkleber ist.
7. Trägerband nach einem der Ansprüche 1 bis 5,

**dadurch gekennzeichnet,**

daß der als Basismaterial dienende Kleber ein Epoxikleber ist.
8. Trägerband nach einem der Ansprüche 1 bis 5,

**dadurch gekennzeichnet,**

daß der als Basismaterial dienende Kleber ein Acrylkleber ist.
9. Trägerband nach einem der vorhergehenden Ansprüche,

**dadurch gekennzeichnet,**

daß die Leitfähigkeit der Kleberschicht (2) maximal so bemessen ist, daß sowohl Treiber von Ausgangsstufen eines auf dem Trägerband zu montierenden Halbleiterchips (1) als auch Eingänge des Halbleiterchips (1) ansteuernde externe Beschaltungen noch in der Lage sind, zu einem ordnungsgemäßen Betrieb des Halbleiterchips (1) notwendige elektrische Signale einwandfrei zu erzeugen.
10. Trägerband nach einem der vorhergehenden Ansprüche,

**dadurch gekennzeichnet,**

daß die Kleberschicht (2) alle Leiterbahnen (5) des Halbleiterchips (1) hochohmig miteinander verbindet.

# FIG 1

# FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | PATENTS ABSTRACTS OF JAPAN, Band 7, Nr. 280 (E-216)[1425], 14. Dezember 1983; & JP-A-58 158 953 (HITACHI SEISAKUSHO K.K.) 21-09-1983 | 1 | H 01 L 23/48<br>H 01 L 23/56 |
| A | Idem | 2,3,5, 7,9,10 | |
| D,Y | DE-A-2 414 297 (SIEMENS)<br>* Anspruch 1 * | 1 | |
| A | | 7 | |
| A | DE-A-3 414 961 (SHARP)<br>* Anspruch 1 * | 2 | |
| A | PATENTS ABSTRACTS OF JAPAN, Band 7, Nr. 162 (E-187)[1307], 15. Juli 1983; & JP-A-58 71 644 (FUJITSU K.K.) 28-04-1983 | 5,6,10 | RECHERCHIERTE SACHGEBIETE (Int. Cl.4) |
| A | FR-A-2 376 520 (RTC)<br>* Ansprüche 1,3,6 * | 2,4,10 | H 01 L |

Der vorliegende Recherchenbericht wurde für alle Patentansprüche erstellt.

| Recherchenort | Abschlußdatum der Recherche | Prüfer |
|---|---|---|
| DEN HAAG | 05-12-1986 | DE RAEVE R.A.L. |